# EUROPÄISCHE PATENTANMELDUNG

(11) **EP 0 905 828 A2**
(43) Veröffentlichungstag der Anmeldung: **31.03.1999**
(21) Anmeldenummer: 98117385.9
(22) Anmeldetag: 15.09.1998
(51) Int. Cl.: H01R 29/00

(54) **Vorrichtung zur Identifizierung von elektronischen Geräten**

(30) Priorität: 30.09.1997 DE 19743280
(71) Anmelder: Siemens Nixdorf Informationssysteme AG, 33106 Paderborn (DE)
(72) Erfinder: Schlosser, Stephan, 86159 Augsburg (DE)
(74) Vertreter: Epping, Wilhelm, Dr.-Ing.

(57) **Zusammenfassung**

Die an einer Gehäusewandung (A) vorgesehenen Markierungen sind aus wenigstens zwei schlitzartigen, durch Querstege (Q2,Q4) kodierbaren Aussparungen (A1...A4) gebildet, wobei längs dieser Aussparungen einzelne Leiterbahnen (L1...L4) geführt sind, die im Bereich der Querstege (Q2,Q4) eine Sollbruchstelle (SB1...SB4) aufweisen. Ein Kodierstecker (C) mit mehreren, den einzelnen Aussparungen zugeordneten kammartig angeordneten Stegen, die im Bereich der Querstege eine Einkerbung (E1...E4) aufweisen, bewirkt, dass die Leiterbahnen (L1...L4) bei vorhandenem Quersteg (Q2,Q4) an der Sollbruchstelle (SB2,SB4) unterbrochen werden. Die Leiterbahnen (L1...L4) sind an einem Ende jeweils getrennt mit einer Auswertelogik und am anderen Ende über eine gemeinsame Rückleitung (RL) mit einem Bezugspotential verbunden, so dass sich für die Kombination aus unterbrochenen und nicht unterbrochenen Leiterbahnen ein entsprechendes Binärsignal ergibt.

## Beschreibung

Die Erfindung betrifft eine Vorrichtung nach den Merkmalen des Oberbegriffs des Anspruchs 1.

Für den Kundendienst, die Wartung und die Administration von elektronischen Geräten, insbesondere Computersystemen, ist die frühe und zuverlässige Information über Art und Konfiguration des jeweiligen Gerätes von großer Bedeutung, wenn Fehler möglichst schnell behoben, Wartungsarbeiten umgehend durchgeführt und Ersatzteile frühzeitig bereitgestellt werden sollen. Eine wichtige Information ist dabei insbesondere der Gerätetyp bzw. das zu diesem Gerätetyp gehörende Gehäuse, weil anhand des Gehäuses auch gewisse Rückschlüsse auf die einzelnen Systemkomponenten gezogen werden können.

Da die Ermittlung des Gehäusetyps beim Kunden nicht selten auf Schwierigkeiten stößt, besteht bei den Wartungs- und Kundendienststellen zunehmend der Wunsch, diese Information nicht mehr durch bloßen Augenschein seitens des Kunden, sondern elektronisch zu erfassen mit dem Vorteil, dass diese Information bei vernetzten Systemkomponenten, zum Beispiel vom Systemboard eines Personalcomputers über das Datennetz abgerufen werden kann.

Der vorliegenden Erfindung liegt nun die Aufgabe zugrunde, für die datentechnische Erfassung und Übertragung von den jeweiligen Gehäusetyp spezifizierenden Information eine möglichst einfach realisierbare Vorrichtung zu schaffen.

Diese Aufgabe wird erfindungsgemäß durch die Merkmale des Anspruchs 1 gelöst. Vorteilhafte Weiterbildungen der Erfindung sind in Unteransprüchen angegeben.

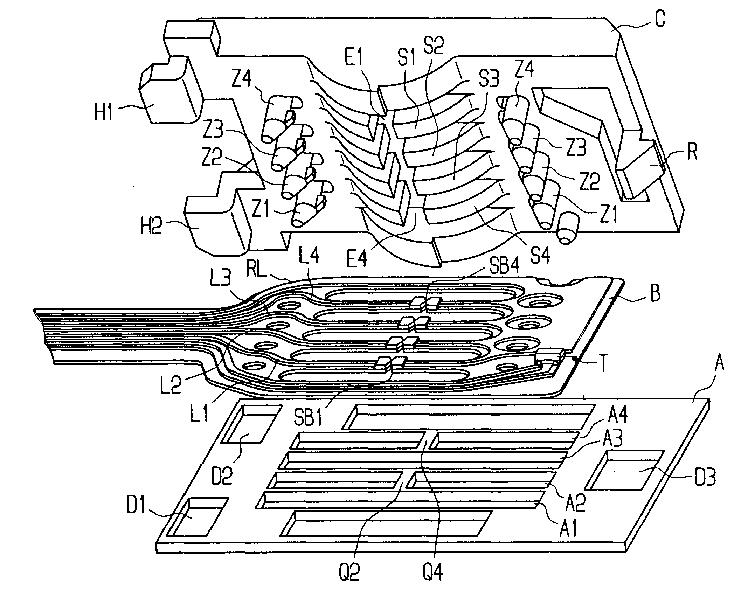

Im Folgenden wird ein Ausführungsbeispiel der Erfindung anhand der Zeichnung näher erläutert, und zwar anhand einer einzigen Figur, die die erfindungsgemäß ausgebildete Vorrichtung in einer Explosionsdarstellung zeigt.

Diese Vorrichtung besteht aus insgesamt drei Komponenten, und zwar aus einem in einer Gehäusewandung A vorgesehenen Kodierbereich, einer Streifenleiteranordnung B und einem Kodierstecker C. Die wesentliche Komponente, die eine eindeutige Identifikation des Gehäuses ermöglicht, ist der in der Gehäusewandung A vorgesehene Kodierbereich, der durch eine Kombination von Binärstellen in Form von Aussparungen einer ersten und zweiten Art gebildet ist. Im gezeigten Beispiel sind es parallel zueinander verlaufende schlitzartige Aussparungen A1...A4, wobei die Aussparungen A2 und A4 durch je einen Quersteg Q2 und Q4 in jeweils zwei, vorzugsweise gleich große Abschnitte unterteilt sind.

Auf diesen, in der Gehäusewandung durch einen Stanzvorgang gebildeten Kodierbereich, der den jeweiligen Gehäusetyp eindeutig identifiziert, ist ein Kodierstecker C aufsetzbar, der unter anderem mehrere, der Zahl der Aussparungen A1 bis A4 entsprechende, kammartig angeordnete Stege S1...S4 aufweist. Diese Stege S1...S4, die bei aufgesetztem Kodierstecker C in die Aussparungen A1...A4 der Gehäusewandung A eintauchen, haben in etwa das Profil eines Kreisbogenabschnitts und weisen jeweils im Querstegbereich eine Einkerbung E1...E4 auf. Auf diesen Kodierstecker wird nun der Endabschnitt einer Streifenleitung B aufgesetzt, die mehrere, jeweils den Stegen S1...S4 zugeordnete Leiterbahnen L1...L4 aufweist. Fluchtend zu den einzelnen Leiterbahnen sind beidseitig mehrere Zentrierstifte Z1...Z4 vorgesehen, die in entsprechende Lochaussparungen LA1...LA4 in der Streifenleitung B eintauchen und auf diese Weise sowohl für eine Zugentlastung als auch für eine lagegerechte Fixierung der Streifenleitung B am Kodierstecker C sorgen.

Die Streifenleitung B besteht aus einem dünnen flexiblen, isolierenden Trägermaterial, zum Beispiel einer Folie aus Polyester, Polykarbonat oder Polyamid, auf dem mehrere Leiterbahnen, beispielsweise durch Bedrucken mit Silberleitpaste aufgetragen sind. In der dem Kodierbereich zugeordneten Abschnitt der Streifenleitung sind die Leiterbahnen L1...L4 durch Trennschlitze voneinander getrennt. Darüber hinaus weisen diese Leiterbahnen im Bereich der Querstege des Kodierbereichs je eine Sollbruchstelle SB1...SB4 auf, deren Funktion noch erläutert wird.

Beim Aufsetzen des Kodiersteckers C samt Streifenleitung B auf den Kodierbereich der Gehäusewandung A geschieht nun Folgendes. Die auf den kammartig angeordneten Stegen S1...S4 verlaufenden Leiterbahnen L1 L4 tauchen in die jeweiligen Aussparungen A1...A4 ein, wobei, sofern eine Leiterbahn auf einen Quersteg trifft - im dargestellten Beispiel gilt dies für die Leiterbahnen L2 und L4 - diese Leiterbahnen an ihrer Sollbruchstelle SB2 und SB4 durchtrennt werden. Beim Aufsetzen des Kodiersteckers tauchen ausserdem die Zentrierstifte Z1...Z4 in die jeweiligen Endbereiche der Aussparungen A2...A4 ein. Die mechanische Fixierung des Kodiersteckers C erfolgt einerseits über hintergreifende Haltehaken H1, H2, die in Durchbrüchen D1, D2 in der Gehäusewandung A gelenkartig gehalten werden und andererseits durch einen gegenüberliegend vorgesehenen Rasthaken R, der in einen entsprechenden Durchbruch D3 in der Gehäusewandung A eintaucht.

Die einzelnen Leiterbahnen L1...L4 der Streifenleitung B werden an einem Ende mit einer Auswertelogik verbunden, die je nachdem, ob die Leitung durch Scherung am Quersteg Q2, Q4 unterbrochen ist oder nicht, ein entsprechendes Binärsignal abfragen kann. Am anderen Ende sind die Leiterbahnen L1...L4 an eine gemeinsame Rückleitung RL angeschlossen, die ebenfalls zur Auswertelogik zurückgeführt wird und dort an ein Bezugspotential angeschlossen isit. Auf diese Weise wird mittels der in der Gehäusewandung vorhandenen Kodierung - Aussparung mit/ohne Quersteg - über die am Bezugspotential anliegenden Leiterbahnen L1, L3 oder unterbrochenen Leiterbahnen L2, L4 ein der Gehäusekodierung entsprechendes binäres Signalmuster erzeugt, das DV-technisch abgefragt, an eine zum Beispiel am Systemboard eines Personalcomputers vorgesehene Auswertelogik weitergeleitet und schließlich über ein Datennetz an die Kundendienststelle übertragen werden kann.

Weitere Sensorfunktionen für andere physikalische Größen, wie zum Beispiel eine Temperaturüberwachung, können durch zusätzlich im Sensorbereich aufgebrachte elektronische Bauteile, z. B. Temperaturfühler T, und durch zusätzliche Signalleitungen zur Auswertelogik mit der Funktion der Gehäuseidentifikation kombiniert werden.

## Patentansprüche

1. Vorrichtung zur Identifizierung von elektronischen Geräten anhand von am Gerät angebrachten gerätespezifischen Markierungen,
**dadurch gekennzeichnet,**
dass die an einer Gehäusewandung (A) vorgesehenen Markierungen aus wenigstens zwei schlitzartigen, durch Querstege (Q2,Q4) kodierbaren Aussparungen (A1...A4) gebildet sind, dass längs dieser Aussparungen (A1...A4) einzelne Leiterbahnen (L1...L4) geführt sind, die im Bereich der gegebenenfalls vorhandenen Querstege (Q2,Q4) eine Sollbruchstelle (SB1...SB4) aufweisen, dass ein Kodierstecker (C) mit mehreren, den einzelnen Aussparungen (A1...A4) zugeordneten kammartig angeordneten Stegen (S1...S4) vorgesehen ist, dass die kammartig angeordneten Stege (S1...S4) des Kodiersteckers (C), die bei gestecktem Kodierstecker (C) in die Aussparungen (A1...A4) eintauchen, im Bereich der Querstege eine Einkerbung (E1...E4) aufweisen, so dass die Leiterbahnen (L1...L4) bei vorhandendem Quersteg (Q2, Q4) aufgrund einer Scherbewegung im Bereich der Sollbruchstelle (SB2, SB4) unterbrochen werden und dass die Leiterbahnen (L1...L4) an einem Ende jeweils getrennt mit einer Auswertelogik und am anderen Ende über eine gemeinsame Rückleitung (RL) mit einem Bezugspotential verbunden sind.

2. Vorrichtung nach Anspruch 1,
**dadurch gekennzeichnet,**
dass die einzelnen Leiterbahnen (L1,L4) und die Rückleitung (RL) auf einer gemeinsamen folienartigen Streifenleitung (B) angeordnet sind, und dass im Bereich des Kodiersteckers (C) zwischen den einzelnen Leiterbahnen (L1...L4) Trennschlitze vorgesehen sind.

3. Vorrichtung nach Anspruch 1 oder 2,
**dadurch gekennzeichnet,**
der Kodierstecker (C) wenigstens zwei Zentrierstifte (Z1...Z4) aufweist, an denen die mit entsprechenden Lochaussparungen versehene Streifenleitung (B) aufsetzbar ist.

4. Vorrichtung nach einem der vorhergehenden Ansprüche,
**dadurch gekennzeichnet,**
dass die Streifenleitung (B) zusätzliche Signalleiter zur Übertragung weiterer Sensorsignale, wie Temperaturangaben oder dergleichen, aufweist.

5. Vorrichtung nach einem der vorhergehenden Ansprüche,
**dadurch gekennzeichnet,**
dass am Kodierstecker (C) und am Kodierbereich der Gehäusewandung (A) jeweils zugeordnete, ineinandergreifende Rastelemente vorgesehen sind.

6. Vorrichtung nach Anspruch 5,
**dadurch gekennzeichnet,**
dass am Kodierstecker (C) hintergreifende Haltehaken (H1,H2) und wenigstens ein federnder Rasthaken (R) vorgesehen sind, die in entsprechende Durchbrüche (D1,D2,D3) in der Gehäusewandung (A) eintauchen.
